Europäisches Patentamt

European Patent Office

Office européen des brevets

(11) Veröffentlichungsnummer: **0 314 995 B1**

# EUROPÄISCHE PATENTSCHRIFT

(45) Veröffentlichungstag der Patentschrift: **22.07.92**

(21) Anmeldenummer: **88117548.3**

(22) Anmeldetag: **21.10.88**

(51) Int. Cl.⁵: **H03J 7/00**

---

(54) **Empfänger für das Radio-Daten-System.**

---

(30) Priorität: **05.11.87 DE 3737535**

(43) Veröffentlichungstag der Anmeldung:
**10.05.89 Patentblatt 89/19**

(45) Bekanntmachung des Hinweises auf die
Patenterteilung:
**22.07.92 Patentblatt 92/30**

(84) Benannte Vertragsstaaten:
**AT CH DE ES FR GB IT LI SE**

(56) Entgegenhaltungen:
**DE-A- 3 149 409**
**DE-A- 3 432 848**
**DE-A- 3 448 043**
**DE-U- 8 717 290**

**NACHRICHTEN TECHNISCHE ZEITSCHRIFT**
**N.T.Z., Band 40, Nr. 5, 1987, Seiten**
**346-348,350,351; F. STOLLENWERK: "RDS -**
**Ein neuer Dienst im UKW-Rundfunk"**

(73) Patentinhaber: **Blaupunkt-Werke GmbH**
**Robert-Bosch-Strasse 200**
**W-3200 Hildesheim(DE)**

(72) Erfinder: **Die Erfinder haben auf ihre Nennung verzichtet**

(74) Vertreter: **Eilers, Norbert, Dipl.-Phys.**
**Blaupunkt-Werke GmbH Robert-Bosch-Strasse 200**
**W-3200 Hildesheim(DE)**

---

## Beschreibung

Der Gegenstand des Schutzrechts gehört zum Bereich der Empfänger für das Radio-Daten-System.

Im Radio-Daten-System RDS werden über einen Hilfsträger von 57 kHz digitale Signale von den zugehörigen Rundfunksendern ausgestrahlt und von geeigneten Empfängern empfangen und ausgewertet. Die Daten übertragung erfolgt nach einer EBU-Spezifikation 3244, deren letzte Fassung im Januar 1987 verabschiedet wurde. Ausführlich beschrieben ist der neue Dienst u. a. in der NTZ, Band 40, 1987, Heft 5, Seite 346 ff. Dort ist auch ein Blockschaltbild eines RDS-Empfängers als Bild 5 wiedergegeben.

In diesem Aufsatz ist ferner eine Zusammenstellung der laut der EBU-Spezifikation mittels RDS übertragbaren Informationen enthalten. Zu diesen Informationen gehören danach auch "Alternative Frequenzen". Diese sind in dem Aufsatz wie folgt definiert worden

Alternative Frequenzen, AF: Durch die Übertragung einer Liste von Frequenzen der Sender, die der gleichen Programmkette angehören, wird Empfängern, die über einen Speicher für diese Liste verfügen, ermöglicht, die Umschaltzeit auf einen anderen programmgleichen Sender zu reduzieren. Dieser RDS-Service ist besonders beim mobilen Empfang von Nutzen.

Aufwendige senderseitige Maßnahmen zur Ausstrahlung der alternativen Frequenzen sind in den DE-C-34 32 848 beschrieben. Diese sind als Alternative B in der erwähnten EBU-Spezifikation enthalten und werden von einigen deutschen Sendern benutzt.

In dem aus dem genannten Schutzrecht ausgeschiedenen DE-C-34 48 043 sind Angaben zur empfängerseitigen Auswertung dieser Ausstrahlungsart enthalten. Danach werden auf den einzelnen Sendeturm bezogene Listen der alternativen Frequenzen senderseitig zusammengestellt und nacheinander auf dem 57-kHz-Träger ausgestrahlt, wobei die Frequenz des Sendeturms der zugeordneten Liste vorangestellt ist. Im Empfänger bleiben die empfangenen Informationen solange unbeachtet, bis eine Vergleichsstufe feststellt, daß in der dem Listenanfang zugeordneten Position die Frequenz erscheint, die der im Empfänger gerade eingestellten Empfangsfrequenz entspricht. Dann werden alle nachfolgend empfangenen Frequenzangaben als alternative Frequenzen zwischengespeichert. Die Speicherung wird beendet, sobald die genannte Vergleichsstufe das Eintreffen einer neuen Frequenz signalisiert.

Das bekannte Verfahren ist sehr zeitaufwendig und zudem störanfällig, da ein Nichterkennen einer Frequenz am Listenanfang entweder ein Ausbleiben der Zwischenspeicherung der Liste der alternativen Frequenzen zur Folge hat oder - falls die Zwischenspeicherung nicht rechtzeitig beendet wird - die Liste um die alternativen Frequenzen des nächstfolgenden Sendeturms fälschlicherweise erweitert wird. Ist die Zwischenspeicherung unterblieben, dann müssen erst alle anderen Listen gesendet sein, bis ein neuer Versuch zur Zwischenspeicherung der Liste, die dem im Empfänger eingestellten Sendeturm zugeordnet ist, unternommen werden kann. Der Durchlauf aller Listen erfordert einen Zeitbedarf von bis zu 2 Minuten.

Ein Empfänger, dessen Schaltung entsprechend den Merkmalen des Hauptanspruchs ausgelegt ist, vermag alternative Frequenzen schneller für den Empfänger zur Verfügung zu stellen.

Anhand der Blockschaltbilder wird ein Ausführungsbeispiel der Erfindung näher erläutert.

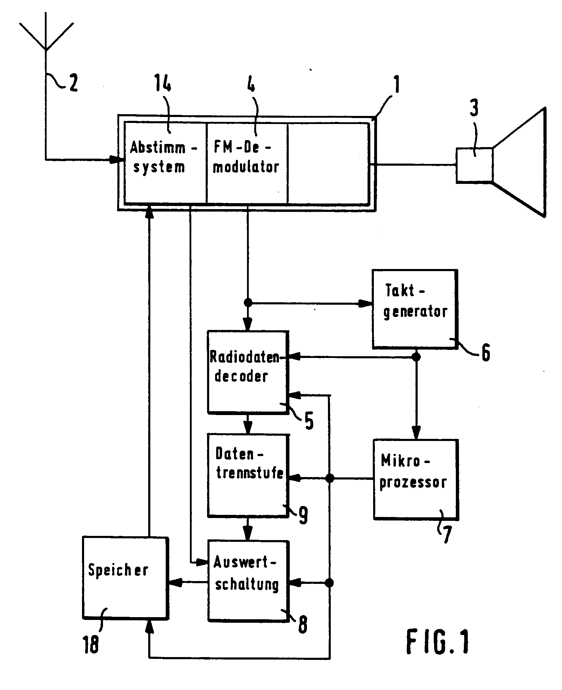

Mit 1 ist in Figur 1 ein üblicher UKW-Empfänger bezeichnet, der über eine Antenne 2 einen in der Frequenz mit Nutzsignalen modulierten Träger empfängt, auf dessen Frequenz der Empfänger abgestimmt ist und der von einem bestimmten Sendeturm abgestrahlt wird. Die im Basisband liegenden Nutzsignale werden über einen Lautsprecher 3 wiedergegeben.

Hinter dem FM-Demodulator 4 im Empfänger 1 ist ein Radiodatendecoder 5 in bekannter Weise angeschlossen. Der Decoder entnimmt dem vom Träger getrennten Multiplexsignal den in der Amplitude modulierten 57-kHz-Hilfsträger und stellt an seinem Ausgang einen Fluß von digitalen Daten zur Verfügung. Deren Ausgabe und Weiterverarbeitung wird von einem Taktgenerator 6 synchronisiert und von einem Mikroprozessor 7 gesteuert. Die digitalen Daten werden in einer diskret aufgebaute Baugruppen umfassenden Auswerteschaltung 8 weiterverarbeitet.

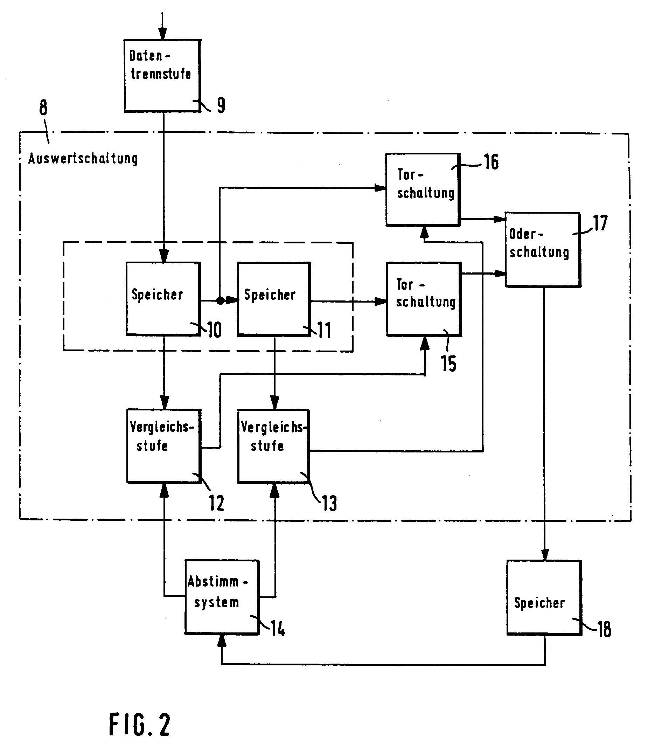

Die Auswerteschaltung 8 umfaßt nach Fig. 2 einen Doppelspeicher für zwei Frequenzangaben, die u. a. in dem Datenfluß an vorgegebener Stelle enthalten sind. Der Datenfluß erreicht den ersten Speicher 10 des Doppelspeichers über die Datentrennstufe 9 und wird vom ersten Speicher 10 an den zweiten Speicher 11 weitergeleitet.

(Alternativ kann auch die Datentrennstufe 9, wenn sie in einem ersten Takt mit dem Eingang des ersten Speichers verbunden ist, in einem zweiten Takt mit dem Eingang des zweiten Speichers verbunden werden.)

Die beiden Speicher weisen je einen Leseausgang auf, der jeweils mit dem Eingang je einer Vergleichsstufe 12, 13 verbunden ist. Die zweiten Eingänge der Vergleichsstufe 12, 13 sind an die Datenausgabeleitung des Abstimmsystems 14 angeschlossen, an dem Daten über die eingestellte Empfangsfrequenz entnehmbar sind.

Der Ausgang der Vergleichsstufe 12, die dem ersten Speicher 10 zugeordnet ist, ist mit dem Steuereingang einer Torschaltung 15 verbunden, die im Datenausgang des Speichers 11 liegt.

Entsprechend ist der Ausgang der Vergleichsstufe 13, die dem zweiten Speicher 11 zugeordnet ist, mit einer Torschaltung 16 verbunden, die im Datenausgang des Speichers 12 liegt.

Die Ausgänge beider Torschaltungen sind an einer Oderschaltung 17 angeschlossen, die im Eingang eines Speichers 18 für die Speicherung alternativer Frequenzangaben liegt. Dieser Speicher ist in bekannter Weise in die Suchlaufschaltung des RDS-Empfängers eingefügt.

Aus dem Datenfluß am Ausgang des RDS-Decoders werden über den Mikroprozessor 7 die darin enthaltenen alternativen Frequenzangaben ausgeblendet.

Nach den Vorschriften der EBU finden sich diese Frequenzangaben in dem Block C des Datentelegramms, wenn zuvor im Block B das zugeordnete Schlüsselwort ermittelt wurde.

Die Übertragung der Frequenzangabe erfolgt paarweise.

Die Übertragungsweise baut auf dem Vorschlag der Übertragung der sogenannten Mielke-Listen nach dem bereits erwähnten DBP 34 32 848 auf. Dieser Vorschlag besagt, daß jeder Sendeturm, der zu einem Senderverbund gehört, die alternativen Frequenzen für alle Sendertürme in Listenform aussendet. Daher wird in einem ersten Paar die Sendefrequenz des ersten Sendeturms und die Zahl der alternativen Frequenzen ausgestrahlt. Dann folgen die alternativen Frequenzen paarweise selbst nacheinander. Anschließend wird die Sendefrequenz des zweiten Sendeturms und die Zahl der dort verfügbaren alternativen Frequenzen und danach diese selbst wieder paarweise ausgestrahlt. Anschließend wird die Sendefrequenz des dritten Sendeturm übertragen, bis schließlich die Sendefrequenz des letzten Sendeturms und die diesem zugehörigen alternativen Frequenzen ausgestrahlt worden sind.

Dieser Vorschlag wurde später dahingehend abgeändert, daß bei der Übertragung jeder alternativen Frequenz zusätzlich die Sendefrequenz des Sendeturms wiederholt wird, so daß jede alternative Frequenz mit der Sendefrequenz des Sendeturms nochmals gepaart ist, d. h. in jedem Frequenzpaar nur eine neue Information übermittelt wird.

Die paarweise Ausstrahlung je einer Sendeturmfrequenz und einer alternativen Frequenz eröffnet, wie die Erfinder erkannt haben, eine schneller arbeitende Alternative zur Auswertung der Mielke-Listen nach DE-C-34 48 043 und für die Aufnahme der alternativen Frequenzen aus dem empfangenen Datenfluß. Diese Alternative läuft in der zu diesem Zweck aufgebauten, eingangs näher erläuterten Schaltung wie folgt ab.

Das aus Block C ausgefilterte Frequenzpaar steht für die Weiterverarbeitung zunächst als serielle Eingabe zur Verfügung. Für die Weiterverarbeitung ist aber die gleichzeitige Verfügbarkeit beider Frequenzen erforderlich. Die beiden Frequenzen werden daher in zwei Zwischenspeichern 10, 11 eingelesen, die z. B. als Schieberegister ausgebildet sein können. Der Inhalt beider Zwischenspeicher wird in der jeweils zugeordneten Vergleichsstufe 12, 13 mit der eingestellten Empfangsfrequenz 14 verglichen.

Stimmt in einem der Speicher die gespeicherte Frequenz mit der eingestellten Empfangfrequenz überein, so stellt die andere Frequenz des Frequenzpaares eine alternative Frequenz dar. Zur Übernahme dieser Frequenz als alternative Frequenz in den entsprechenden Speicher 18 der Suchlaufschaltung des RDS-Empfängers wird durch die Vergleichsschaltung die Torschaltung im Ausgang desjenigen Speichers freigegeben, der die von der eingestellten Empfangsfrequenz abweichende alternative Frequenz enthält.

Ein solcher Betriebsfall, bei dem in einem der Speicher die eingestellte Empfangsfrequenz enthalten ist, stellt sich nun nicht nur ein bei dem Empfang der Liste alternativer Frequenzen, an deren Anfang die im Empfänger eingestellte empfangene Frequenz steht, sondern ergibt sich auch dann, wenn am Anfang der Liste die Frequenz eines anderen Sendeturms steht, aber die im Empfänger eingestellte Frequenz zu den alternativen Frequenzen dieser Turmfrequenz gehört. In dieser Liste taucht die gerade im Empfänger eingestellte Frequenz nur einmal auf und steht bei der Paarbildung an "zweiter" Stelle. Auch in diesem Fall steht aber schließlich in den beiden Speichern zusammengesehen ein Frequenzpaar, von denen eine Frequenz der im Empfänger eingestellten Frequenz entspricht, während die andere Frequenz eine alternative Frequenz zu der eingestellten Frequenz ist.

Wird die dem anderen Sendeturm zugeordnete Liste alternativer Frequenzen vor der dem eingestellten Sender entsprechenden Liste ausgestrahlt, dann kann die Auflistung alternativer Frequenzen für die eingestellte Empfangsfrequenz also bereits vor dem Empfang der Liste beginnen, an deren Anfang die im Empfänger eingestellte Frequenz zu finden ist.

**Patentansprüche**

1. Empfänger
   für das Radiodatensystem
   mit einem Abstimmsystem, dem Daten über die Frequenz des eingestellten Senders entnehmbar sind,
   mit einem Radiodatendecoder (5),
   mit einem Microprozessor (7),

mit einem Speicher (18) für alternative Frequenzangaben, der mit dem Abstimmsystem mindestens zeitweise verbunden ist und mit einer Einrichtung (8), die aus dem Radiodatensignal die alternativen Frequenzangaben entnimmt und in den Speicher eingibt, dadurch gekennzeichnet, daß die Einrichtung zwei Zwischenspeicher (10, 11) für zwei Frequenzangaben umfaßt, jeder Zwischenspeicher über eine Leseleitung mit einer Vergleichsstufe (12, 13) verbindbar ist, die andererseits auch an die Datenausgabeleitung des Abstimmsystems (14) anschließbar ist, daß im Ausgang jedes Zwischenspeichers eine Torschaltung (15, 16) mit einem Steuereingang liegt, der mit dem Ausgang der Vergleichsstufe verbunden ist, welche an die Leseleitung des anderen Zwischenspeichers angeschlossen ist und daß die Ausgänge der Torschaltungen über eine Oderschaltung (17) mit dem Eingang des Speichers für die alternativen Frequenzen (18) verbunden sind.

## Claims

**1.** Receiver for the radio data system, comprising a tuning system from which data can be taken via the frequency of the selected transmitter, with a radio data decoder (5), with a microprocessor (7), with a store (18) for alternative frequency information items which is at least temporarily connected to the tuning system, and with a device (8) which takes the alternative frequency information items from the radio data signal and inputs these information items into the store, characterised in that the device comprises two buffer stores (10, 11) for two frequency information items, each buffer store can be connected by a read line to a comparison stage (12, 13) which, on the other hand, can also be connected to the data output line of the tuning system (14), in that, in the output of each buffer store, a gate circuit (15, 16) having a control input is located which is connected to the output of the comparison stage which is connected to the read line of the other buffer store, and in that the outputs of the gate circuits are connected via an OR circuit (17) to the input of the store for the alternative frequencies (18).

## Revendications

**1.** Récepteur pour un système de données radio comprenant :
- un système d'accord qui fournit les données concernant la fréquence de l'émetteur réglé,
- un décodeur de données radio 5,
- un microprocesseur 7,
- une mémoire 18 pour les indications de fréquences alternatives, reliée au moins de temps à autre au système d'accord, et
- une installation 18 qui reçoit les indications de fréquences alternatives provenant du signal radio et les introduit dans la mémoire,

récepteur caractérisé en ce que,

l'installation comprend deux mémoires intermédiaires (10, 11) pour deux indications de fréquence, chacune des mémoires intermédiaires pouvant être reliée à un comparateur (12, 13) par une ligne de lecture, qui peut par ailleurs également être reliée à la ligne d'émission de données du système d'accord (14),
- à la sortie de chaque mémoire intermédiaire, il y a une porte (15, 16) avec une entrée de commande reliée à la sortie du comparateur auquel est reliée la ligne de lecture de l'autre mémoire intermédiaire,

et les sorties des portes sont reliées par une porte OU à l'entrée de la mémoire des fréquences alternatives (18).

FIG.1

**FIG. 2**